(19) Europäisches Patentamt
European Patent Office
Office européen des brevets

(11) Publication number: **0 143 597**
**A2**

# (12) EUROPEAN PATENT APPLICATION

(21) Application number: **84308046.6**

(22) Date of filing: **20.11.84**

(51) Int. Cl.⁴: **G 03 C 1/68**

(30) Priority: **25.11.83 US 554886**

(43) Date of publication of application: **05.06.85**
**Bulletin 85/23**

(84) Designated Contracting States: **DE FR GB IT**

(71) Applicant: **MINNESOTA MINING AND MANUFACTURING COMPANY, 3M Center, P.O. Box 33427, St. Paul, MN 55133 (US)**

(72) Inventor: **Kausch, William L. c/o Minnesota Mining and, Manufacturing Company 2501 Hudson Road, P.O. Box 33427 St. Paul Minnesota 55133 (US)**

(74) Representative: **Baillie, Iain Cameron et al, c/o Ladas & Parry Isartorplatz 5, D-8000 München 2 (DE)**

## (54) Negative-acting photoresist composition.

(57) Negative-acting photoresist compositions are used in a variety of reproductive and imaging systems. Significant problems with these compositions are their inability to cure to a tough, solvent resistant state, tackiness in the uncured compositions, and the tendency of the uncured compositions to flow under force. The present composition combines six ingredients to form a photoresist composition which overcomes many of these problems in the prior art.

# NEGATIVE-ACTING PHOTORESIST COMPOSITION

## Field of the Invention

This invention relates to negative-acting photoresist compositions, and particularly negative-acting photoresist compositions which are useful in non-silver halide graphic arts films and resist imaging systems.

## Background of the Invention

Negative-acting photoresist compositions have been used commercially for many years. These compositions are applied as a layer over a substrate and then subjected to actinic radiation. The actinic radiation causes a change in solubility of the layer, usually by photoinitiated polymerization of components within the layer. When the imaged layer is subsequently treated (e.g., washed and lightly scrubbed) with a developer solution, such as an aqueous alkaline solution of pH greater than 12, the non-light struck areas of the layer are washed away. If the original layer contained a colorant material (e.g., dyes or pigment), development would leave an imagewise distribution of the colored layer as a final image. If an etching or plating process is performed on the developed layer, an etched or plated image is deposited on the substrate in the exposed areas where the photoresist layer had been removed by development. A wide variety of photoresist compositions exist in the art, and many have been used as photosensitive printing plate compositions in lithographic technology. Examples of photoresist compositions known in the art include U.S. Patent Nos. 3,395,016, 3,469,982, 3,639,185 and 4,193,797, as well as Canadian Patent Nos. 976,352 and 976,353.

Most of the negative-acting photoresist compositions known in the art use ethylenically unsaturated materials in combination with a free radical generating photoinitiator as the active ingredients. Acrylic functional materials (i.e., acrylyol and methacrylyol functional materials) are generally preferred in the art because of their speed, toughness upon cure, and moderate

cost. Printing plate compositions, in particular, rely on the use of acrylic functional materials in various forms such as monomers, oligomers and polymers with acrylic functionality. Examples of such printing plate compositions and the use of various acrylic functional materials are shown, for example, in U.S. Patent Nos. 4,316,949, 4,228,232, 4,104,072 and 3,954,475. Many of these compositions have found acceptable commercial uses, but they have tended to be weak in certain technically important areas, particularly toughness of the cured composition, tackiness of the uncured composition, and cold flow of the resist layer.

The most commonly used imaging systems are based on silver halide technology, diazonium salt technology, or photopolymerizable composition technology. Each of these different systems has its own advantages and problems.

Silver halide films are the most widely used graphic arts material. These films show high resolution, high imaging speeds, and consistency in their performance. However, because of the cost of silver, systems using silver halide emulsions are becoming economically disadvantageous. Other disadvantages include the requirement for multiple steps in processng, unstable processing solutions, and lack of dimensional stability.

Imaging systems using diazonium salt compositions provide high resolution and are considerably less expensive than silver to produce. The visible image produced by most diazonium salt systems consists of a dye and tends to have limits on the maximum optical densities or image color obtainable, higher minimum densities than desirable, and often suffers from a low contrast. Other disadvantages include image fade on repeated exposure, lack of dimensional stability, surface pin holes, and lack of definition at the image edge. Although thermally developable diazonium salt systems are available in the marketplace, many diazonium salt image systems still rely

upon ammonia development which is undesirable because of the difficulty of working in a closed environment with ammonia. Often the diazo image comprises a dye and is not considered archival in the micrographic context.

Photopolymeric imaging systems are both inexpensive and easy to make. However, these systems usually depend upon the loading of the photopolymeric layer with opacifying material to provide optical density, which tends to reduce the sensitivity of the photosensitive layer.

## Summary of the Invention

The present invention relates to a negative-acting photoresist composition comprising at least six components. The components comprise (1) a polyfunctional acrylate monomer, (2) an organic, polymeric, polyfunctional film-forming binder with pendant acrylate groups, (3) a polyfunctional, thermally activated, acid group-cross-linking agent, (4) an active photosensitive free radical generator, (5) a non-active photosensitive free radical generator, and (6) an acid group bearing polymeric binder. The compositions of the present invention preferably contain a polyfunctional oligomeric acrylate (other than the one used as the film-forming binder with pendant acrylate groups) as a seventh component. Other imaging layer adjuvants such as spectral sensitizers, dyes, pigments, fillers, and coating aids may also be present in the photosensitive layer.

The present invention also relates to a negative-acting photoresist imaging system comprising:

a) a substrate;

b) a metal layer adhered to said substrate;

c) a latently sensitized, crosslinkable, negative-acting photoresist base layer adhered to said metallic layer, said base layer comprising

i) a polyfunctional acrylate monomer;

ii) an organic, polymeric, polyfunctional film-forming binder with more than one acryloyl group pendant therefrom;

iii) a polyfunctional, thermally activated, acid group crosslinking agent;

iv) an acid group-bearing polymeric binder; and

v) a non-active, photosensitive free-radical generator; and

d) a negative-acting photoresist layer adhered to said base layer, said photoresist layer comprising the six component photoresist composition described above.

The base layer and the photoresist layer also preferably contain a polyfunctional, acid group-bearing, oligomeric acrylate (other than the one used as the film-forming binder with pendant acrylate groups). Other imaging layer adjuvants such as dyes, pigments, fillers, and coating aids may be present in the base layer and the photoresist layer. The photoresist layer may also contain spectral sensitizers.

In preferred embodiments of the invention, the imaging system may also contain (1) an organic protective layer applied over the metal layer prior to application of the base layer, (2) a matte top coat applied over the photoresist layer to improve handling characteristics of the film, and/or (3) an anti-static layer applied to the back side of the substrate to further improve the handling characteristics of the film.

The imaging system of the present invention possesses good thermal stability, excellent photosensitivity, and high resolution.

## Detailed Description of the Invention

The negative-acting photoresist composition of the present invention comprises at least six components. The polyfunctional acrylate monomer must have at least two acrylic functionalities thereon (either acrylyol or

methaacrylyol, with 2-8 groups preferred and 3-6 groups most preferred). The monomer should generally be present as 10-50 weight percent of the reactive composition and may comprise more than a single monomer component. Preferably the monomer comprises 30-50 weight percent.

The organic, polymeric polyfunctional pendant acryloyl (including methacryloyl) group bearing film-forming binder should have a molecular weight equal to or greater than 800, and preferably has a molecular weight between 1,000 and 100,000. More preferably, the binder has a molecular weight between 1,000 and 20,000. Any pendant acryloyl group may be present on the binder as on the end of bridging groups such as hydrocarbon chains (e.g., alkylene groups), carbamate groups, etc. The oligomer may have pendant acid groups in addition to the acryloyl groups as disclosed in U.S. Patent No. 4,304,923. The presence of the binder tends to reduce the tackiness of the coated composition and provides cross-linking sites. The binder should be present in an amount between 10-60 weight percent of the composition or the reactive components in the photosensitive layer.

The polyfunctional, thermally activated acid reactive cross-linking agent should be present in an amount between 0.05 and 2.5% by weight of the composition or the reactive components. This component can be used to reduce the cold flow of the resist and reduce tack of the applied resist layer.

The active photosensitive free radical generator should be present in an amount between 1 and 10% by weight of the composition or the reactive components of the photosensitive layer. The non-active photosensitive free radical generator should also be present in an amount of 1 - 10% by weight of reactive components of the photosensitive layer. The combination of these two materials provides a synergistic activity to the photosensitive properties of the composition, and the use of the active photosensitive free radical generator tends

to remove some amount of low molecular weight materials from the composition which acts to further toughen the polymerized product.

The terms "active" and "non-active", as they refer to free radical generators, have definite and critical meansing according to the practice of the present invention. An "active" free radical generator is a compound which, in the absence of any sensitizing compounds, can photoinitiate the cure of a 3 micrometer wet thickness film of methylmethacrylate to a non-tacky film when present as 5% by weight of the methylmethacrylate and irradiated in the absence of $O_2$ with 3 x $10^{-5}$ ergs/$cm^2$ of 360 to 430 radiation. A "non-active" free radical generator is a compound which is not an active free radical generator at 360-430 nm, but when spectrally sensitized (e.g., with Michler's ketone) will, in combination with the spectral sensitizor perform the function of an active free radical generator. That is, the spectrally sensitized non-active free radical generator will cure a 3 micrometer wet thickness layer of methylmethacryalte to a non-tacky film under the conditions described for the definition of an active photoinitiator. Spectral sensitizers are preferably used in molar proportions of 0.01/1 to to 2/1 for the non-active free radical generator. More preferably ratios of 0.05 to 1.5 are used (sensitizer/photoinitiator). This would be equivalent to .01 to 20% by weight of the reactive components, preferably .05 to 15% by weight of reactive components, and most preferably .05 to 5% by weight of reactive components or the composition. Of course any effective (i.e., spectral sensitizing) amount of a spectral sensitizer is useful.

The acid group bearing polymeric binder should have a molecular weight equal to or greater than 800, and preferably between 1,000 and 100,000. More preferably, the binder has a molecular weight between 1,000 and 20,000. Any pendant acid group may be present in the binder. It is preferred to have carboxylic acid groups, but sulfonic,

phosphoric or carboxylic anhydride groups may also be used. The polymer should have an acid equivalent weight of 1,000 or less. The polymer is not necessarily a film-forming agent. This binder must be present in amounts of 10-60% by weight of the composition.

The optional seventh component, the polyfunctional oligomeric acrylic functional material is useful in amounts up to 60% by weight of the composition or the reactive components of the photosensitive composition. The oligomer is preferably present in an amount of between 1 and 60% by weight. The oligomer preferably has a molecular weight greater than 5,000 and less than 50,000, more preferably between 5,000 and 30,000, and most preferably between 10,000 and 15,000. Examples of preferred oligomers are shown in U.S. Patent Nos. 4,316,949, 4,304,923 and 4,153,778. Although the presence of carboxylic acid groups on these oligomers is preferred, their presence is not essential to the practice of the present invention.

The polyfunctional acrylate monomers according to the present invention are well known in the art and include, for example, such materials as the polyacrylate and polymethacrylate esters of alkanepolyols, e.g., pentaerythritol tetraacrylate, tris(2-acryloxyethyl)isocyanurate, tris(2-methyacryloxyethyl) tetrahydrofurfurylmethacrylate, 1-aza-5-acryloxymethyl-3,7-dioxabicyclo [3,0,0] octane (ADOZ), bis[4-(2-acryloxyethyl)phenyl]dimethyl methane, diacetone acrylamide, and acrylamidoethyl methacrylate. Such monomers are disclosed in U.S. Patent Nos. 3,895,949, 4,037,021 and 4,304,923.

The organic polymeric polyfunctional acid group bearing film-forming binder may comprise any polymeric backbone having acid pendant groups. Preferably the acid pendant groups are selected from carboxylic acid groups, sulfonic acid groups, phosphoric acid groups and anhydrides. Poly(ethylenically unsaturated) addition polymers are preferred for the backbone, but as previously

noted, any polymeric binder with pendant acid groups is useful. The preferred binder according to the practice of the present invention is a copolymer of styrene and maleic anhydride having a molecular weight of between 1,000 and 3,000. These polymers are well-knonw in the art. Examples include commercially available styrene/maleic anhydride copolymers, ethylene/maleic anhydride copolymers, and other carboxylic acid anhydride copolymers with ethylenically unsaturated comonomers.

Any polyfunctional, thermally activated acid reactive cross-linking agent is useful in the practice of the present invention. Any material having at least two groups thermally reactable with the acid functionalities present on the binder would be useful in the practice of the present invention. The preferred class of cross-linking agent includes the aziridines, as disclosed in U.S. Patent Nos. 3,115,482; 3,240,720; 3,318,930; and 3,440,242. All thermally activated epoxy resins will also perform as these acid cross-linking agents. Examples include difunctional cycloaliphatic epoxides such as ERL-4221 available from Union Carbide. Difunctional epoxide-aziridine compounds disclosed in 5,240,720 constitute an example of the usefulness of both epoxides and aziridines. These cross-linking agents should be used in an amount between 0.05 and 2.5 weight percent of the composition or the reactive components of the composition.

Any active photosensitive free radical photoinitiator can be used in the practice of the present invention. The preferred class of materials within this group are the s-triazines as disclosed in U.S. Patent Nos. 3,954,475 and 3,987,037. These materials are generically known as chromophor-substituted vinylhalomethyl s-triazines. These compounds are also acrylate reactive, photosensitive free radical generators and are generally used in amounts of 1 - 10% by weight of the composition, and preferably as 2 - 8% by weight of the composition.

The photosensitive, non-active, free radical generator is a generic class of materials well known in the art. Such materials as photosensitive aromatic iodonium salts, sulfonium salts, benzophenones, phosphonium salts, quinones, nitrozo compounds, mercapto compounds, biimidazoles, triaryl imidazoles and all other non-active photosensitive free radical initiators would be useful in the practice of the present invention. Such free radical generators are disclosed in such art as U.S. Patent Nos. 3,729,313, 3,887,450, 3,895,949, 4,043,819, 4,058,400 and 4,058,401. This photosensitive, non-active, free radical generator is generally used in amounts of 1 - 10% by weight of the composition, and preferably between 1.5 and 7% by weight of the composition.

The polyfunctional acrylate oligomers useful in the practice of the present invention are generally well known in the art. These oligomers comprise intermediate length polymer backbones having pendant acrylic (acrylyol or methacrylyol) or polyacrylic groups. The backbones may comprise a host of materials from various chemical classes such as the polyolyls disclosed in U.S. Patent No. 4,304,923 or other free hydrogen containing backbones which can be reacted with isocyanate or caprolactone terminated acrylic or polyacrylic groups. Preferably the polyfunctional acrylate oligomer has an acrylic equivalent weight between 100 and 5,000, with at least two acrylic groups per molecule. According to the teachings of U.S. Patent No. 4,304,923 which includes the most preferred oligomers of the present invention, as many as 12 or 16 acrylic groups can easily be present on the oligomer. Molecular weights for the oligomer are generally between 3,000 and 50,000, preferably between 5,000 and 30,000, and most preferably between 10,000 and 20,000. The oligomer can be present in amounts up to 60% by weight of the composition, is preferably present in amounts between 1 and 60% by weight, and more preferably is present in amounts between 4 and 40% by weight of the composition.

A wide spectrum of other materials known to be useful in photoresist lithographic compositions can be used according to the present invention. For example, spectral sensitizers for the iodonium salts as disclosed in U.S. Patent No. 4,250,053 may be used, as can Michler's ketone and other sensitizers for either or both of the photosensitive free radical generators. Dyes, pigments, fillers, antistatic agents, lubricants, surfactants, and other coating aids may be used as desired in the present invention.

The negative acting photoresist layer is generally present in an amount of 1 to 3 $g/m^2$, preerably 1.5 to 2.5 $g/m^2$, and more preferably 1.75 to 2.25 $g/m^2$.

The substrate may be any surface or material onto which metal may be vapor-deposited. The substrate may be rough or smooth, transparent or opaque, and continuous or porous. It may be of natural or synthetic polymeric resin (thermoplastic or thermoset), ceramic, glass, metal, paper, fabric, and the like. For most commercial purposes the substrate is preferably a polymeric resin film such as polyester (e.g., polyethylene terephthalate), cellulose ester, polycarbonate, polyvinyl resin (e.g., polyvinyl chloride, polyvinylidene chloride, polyvinylbutyral, polyvinylformal), polyamide, polyimide, polyacrylate (e.g., copolymers and homopolymers of acrylic acid, methacrylic acid, n-butyl acrylate, acrylic anhydride and the like), polyolefin, and the like. More preferably, the substrate is polyester. The substrate should be transparent to actinic radiation in the range of 330 to 450 nm and is preferably smooth and non-porous. It may contain fillers such as those materials generally used in the formation of films such as coating aids, lubricants, antioxidants, ultraviolet radiation absorbers, surfactants, catalysts and the like. The substrate is preferably 25 microns to 250 microns thick, more preferably 100 microns to 200 microns thick.

The vapor-deposited metal layer may be any vapor-deposited metal or metalloid layer. According to the practice of the present invention, the term metal layer is defined as a layer comprising metal, metal alloys, metal salts, and metal compounds. The corresponding meaning applies to the term metalloid layer. The term metal in metal layer is defined in the present invention to include semi-metals (i.e., metalloids) and semiconductor materials. Metals include materials such as aluminum, antimony, beryllium, bismuth, cadmium, chromium, cobalt, copper, gallium, germanium, gold, indium, iron, lead, magnesium, manganese, molybdenum, nickel, palladium, rhodium, selenium, silicon, silver, strontium, tellirium, tin, titanium, tungsten, vanadium, and zinc. Preferably the metal is selected from aluminum, chromium, nickel, tin, titanium and zinc. More preferably the metal is aluminum. Metal alloys such as aluminum-iron, aluminum-silver, bismuth-tin, and iron-cobalt alloys are included in the term metal layer and are useful. Metal salts such as metal halides, metal carbonates, metal nitrates and the like are also useful. Metal compounds such as metal oxides and metal sulfides also have utility in imaging systems. Metal layers comprising mixtures of these materials such as mixtures of metal-metal oxides, metal-metal salts, and metal salts-metal oxides are also of interest.

The thickness of the vapor-deposited metal layer depends upon the particular needs of the final product. In imaging constructions, for example, the thickness should be at least about 500 nm. Generally, the layer would be no thicker than 5000 nm which would require a long etching period. A more practical commercial range would be between 600 and 1500 nm. A preferred range would be between 700 and 1200 nm and a more preferred range would be between 700 and 1000 nm. The optical density of the vapor-deposited metal layer is generally in the range of 2 to 8, preferably 3 to 6, most preferably 4 to 5.

Vapor-deposition of the metal layer may be

accomplished by any means. Thermal evaporation of the metal, ion plating, radio frequency sputtering, A.C. sputtering, D.C. sputtering and other known processes for deposition may be used in the practice of the present invention. The pressure may vary greatly during coating, but is usually in the range of $10^{-6}$ to $10^{-4}$ torr.

In a preferred embodiment of the present invention an organic protective layer is deposited over the metal layer. Examples of such organic protective layers are taught, for example, in U.S. Patent No. 4,405,678, incorporated herein by reference, U.S. Patent No. 4,268,541 and Japanese Patent Publication 56-9736.

The negative-acting photoresist system is a double layer, acrylate-based photopolymerizable system comprising a base layer and a photoresist layer. The base layer is not photosensitive in the 330 to 450 nm exposure window, but can be crosslinked when overcoated with a photosensitized resist coat, that is, the base layer is latently photosensitive. This latent photosensitivity in the base layer aids in developer penetration and clean out in the non-image areas, as well as reducing coating related defects.

The latently sensitized, crosslinkable, negative-acting photoresist base layer contains (i) a polyfunctional acrylate monomer, (ii) an organic polymeric, polyfunctional film-forming binder with more than one acryloyl group pendant therefrom; (iii) a polyfunctional, thermally activated, acid group crosslinking agent; (iv) an acid group-bearing polymeric binder; and (v) a non-active photosensitive free-radical generator.

The polyfunctional acrylate monomers useful in the base layer are coextensive with those useful in the above described six-component photoresist composition. The monomer should generally be present as 10-60 weight percent of the reactive composition and may comprise more than a single monomer component. Preferably, the monomer comprises 30-50 weight percent.

The organic, polymeric polyfunctional pendant acryloyl (including methacryloyl) group bearing film-forming binder should have a molecular weight equal to or greater than 800, and preferably has a molecular weight between 1,000 and 100,000. More preferably, the binder has a molecular weight between 1,000 and 20,000. Any pendant acryloyl group may be present on the binder as on the end of bridging groups such as hydrocarbon chains (e.g., alkylene groups), carbamate groups, etc. The oligomer may have pendant acid groups in addition to the acryloyl groups, as disclosed in U.S. Patent No. 4,304,923. The presence of the binder tends to reduce the tackiness of the coated composition and provides cross-linking sites. The binder should be present in an amount between 10 to 60 weight percent of the composition.

The polyfunctional acrylate oligomers useful in the practice of the present invention are coextensive with those useful in the above-described six component photoresist composition. The oligomer can be present in amounts up to 60% by weight of the composition, is preferably present in amounts between 1 and 60% by weight, and more preferably is present in amounts between 4 and 40% by weight of the composition.

The organic polymeric polyfunctional acid group-bearing binder is also coextensive with those described for the six-component photoresist composition.

The acid group bearing polymeric binder should have a molecular weight equal to or greater than 800, and preferably between 1,000 and 100,000. More preferably, the binder has a molecular weight between 1,000 and 20,000. The polymer is not necessarily a film-forming agent. The preferred binder according to the practice of the present invention is a copolymer of styrene and maleic anhydride having a molecular weight of between 1,000 and 3,000. The binder is preferably present in amounts of 10 to 60% by weight of the composition.

Any polyfunctional, thermally activated acid reactive crosslinking agent is useful in the practice of the present invention. Any material having at least two groups thermally reactable with the acid functionalities present on the binder would be useful in the practice of the present invention. The preferred class of crosslinking agent includes the aziridines, as disclosed in U.S. Patent Nos. 3,115,482; 3,240,720; 3,318,930; and 3,440,242. All thermally activated epoxy resins will also perform as these acid cross-linking agents. Examples include difunctional cycloaliphatic epoxides, such as "ERL-4221", available from Union Carbide. Difunctional epoxide-aziridine compounds disclosed in 3,240,720 constitute an example of the usefulness of both epoxides and aziridines. These cross-linking agents should be used in an amount between 0.05 and 2.5 weight percent of the composition. This component can be used to reduce the cold flow of the resist and reduce tack of the applied resist layer.

A non-active photosensitive free-radical generator, as described for the six-component composition, must also be present in the base layer. This photosensitive, non-active, free radical generator is generally used in amounts of 1 to 10% by weight of the composition, and preferably between 1.5 and 7% by weight of the composition.

An optional component, the polyfunctional, acid group-bearing oligomeric acrylic functional material, is useful in amounts up to 60% by weight of the composition. The oligomer is preferably present in an amount of between 1 and 60% by weight. The oligomer preferably has a molecular weight greater than 5,000 and less than 50,000, more preferably between 5,000 and 30,000, and most preferably between 10,000 and 15,000. Examples of preferred oligomers are shown in U.S. Patent Nos. 4,316,949, 4,304,923 and 4,153,778. This oligomer is like that of the organic, polymeric, polyfunctional pendant acryloyl group-bearing film-forming binder and has pendant

acid groups.

Dyes, pigments, fillers, antistatic agents, lubricants, surfactants, and other coating adjuvents may be used as desired in the base layer.

The latently sensitized, crosslinkable, negative acting photoresist base layer is generally applied at a coating weight of 1.0 to 3.0 $g/m^2$, preferably 1.5 to 2.5 $g/m^2$ and more preferably 1.75 to 2.25 $g/m^2$.

In a preferred embodiment of the invention, a matte top coat is applied over the photoresist layer to improve the handling characteristics of the film, such as the drawdown to printing plates or contact with other films without blocking. This matte top coat provides a nonglossy appearance to the imageable element and can provide a control on the friction characteristics of the surface. Furthermore, if the material is to be stacked or rolled, the protuberance of the matting agent will prevent or reduce adherence between layers caused by the exclusion of air between them. Typical photographic matting agents such as polymethylmethacrylate and its copolymers, silica, and the like are generally useful. The top coat is preferably present in an amount of 0.1 to 2.0 $g/m^2$, more preferably 0.2 to 1.5 $g/m^2$. Top coat compositions which are useful in the present invention include those disclosed in U.S. Patent No. 4,072,527 and U.S. Patent No. 4,072,528.

In a further preferred embodiment of the imaging system of the present invention, an anti-static layer is applied to the back side of the substrate. The use of an anti-static layer serves to further improve the handling characteristics of the film. The antistatic layer is preferably present in an amount of 0.05 to 0.5 $g/m^2$, more preferably 0.1 to 0.3 $g/m^2$. Useful anti-static materials are those which provide the desired anti-static properties at coating levels such that the coating is transparent to actinic radiation in the range of 330 to 450 nm. Particularly useful are conductive polymers, such as those having pendant quaternary groups, and include, for example,

those disclosed inU.S. Patent No. 4,225,334 and U.S. Patent No. 4,214,035.

Examples 1 - 8

A stock solution used in all of the following examples was prepared by mixing, in parts by weight:

| | |
|---|---|
| pentaerythritol tetraacrylate | 28 |
| partially esterified 1:1 styrene: maleic anhydride resin | 38 |
| the reaction product of a 5,000 - 10,000 molecular weight polyol and 0.9 molar equivalents of isocyanatoethylmethacrylate per mole of available hydroxyl groups | 17 |
| the carboxylic acid substituted polyacryloyl functional urethane oligomer of Example 1 of U.S. Patent No. 4,304,923 | 3 |
| cyan dye (Pylam Solvent Blue) | 3 |
| bifunctional aziridine | 0.08 |

The following photoinitiators and sensitizers were used in each of the Examples:

1) 5% by weight s-triazine 2
2) 10% by weight s-triazine 2
3) 4% by weight diphenyliodonium hexafluorophosphate and 2% Michler's ketone (sensitizer)
4) 8% by weight diphenyliodonium hexafluorophosphate and 4% Michler's ketone
5) 5% by weight s-triazine 2 and 2% Michler's ketone
6) 4% by weight diphenyliodonium hexafluorophosphate and 5% s-triazine 2
7) 2% by weight Michler's ketone, 4% by weight diphenyliodonium hexafluorophosphate, and

5% by weight s-triazine 2

8) 2% by weight Michler's ketone,
4% by weight diphenyliodonium hexafluorophosphate,
and
5% by weight s-triazine 1.

s-triazine 1 has the formula

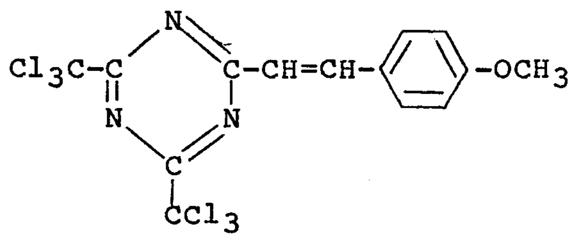

s-triazine 2 has the formula

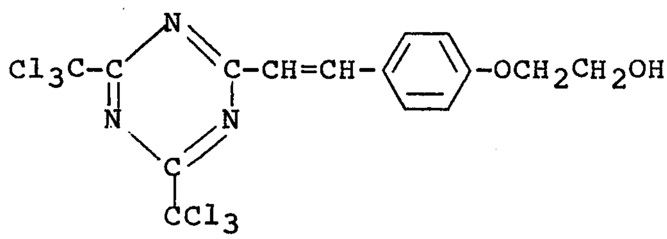

The various coating compositions were applied to a polyester substrate at a coating weight of 350 mg/ft$^2$, exposed in a 2kw lithographic imaging system for 20 seconds, washed and lightly scrubbed with the developer of Example 36 in U.S. Patent No. 4,314,022. The following results were obtained.

| Example | Gray Scale | Image Quality | Dot Quality |
| --- | --- | --- | --- |
| 1 | 2-3 | weak | undercut |
| 2 | 3-4 | weak | undercut |
| 3 | --- | none | none (totally removed) |
| 4 | --- | none | none (totally removed) |
| 5 | 2-3 | weak | undercut |
| 6 | 2-3 | weak | undercut |
| 7 | 6-8 | excellent | hard |
| 8 | 6-8 | excellent | hard |

## Examples 9-12

Four formulations were prepared in order to show a range of materials for the various components used in the practice of the present invention. The following materials were used in those formulations:

A. Triacrylate of tris-hydroxyethyl isocyanurate
B. Trimethylolpropane trimethacrylate
C. Pentaerythritol tetraacrylate
D. Pentaerythritol tetramethacrylate
E. G-cure IEM, as reaction product of G-Cure 867 (Henkel Corp.) with 0.9 moles isocyanatoethylmethacrylate (Dow Chemical Co.) per mole of available hydroxyl groups.
F. Compound A of Example 1 of U.S. Patent 4,249,011
G. Compound P-II of U.S. Patent 4,304,923
H. A polyesterdiol having a molecular weight between 5,000 and 10,000.
I. S-Triazine 2
J. Michler's ketone
K. Diphenyliodonium hexafluorophosphate
L. G-Cure 867 acrylate resin
M. A partial ester of styrene/maleic anhydride
N. Aziridine thermal crosslinker (XAMA 2, Cordova Chemical)

0143597

O. Bifunctional aziridine thermal crosslinker (HX 877, 3M Co.)

P. Aziridine thermal crosslinker (XAMA 7, Cordova Chemical.

The four photosensitive resist compositions were as follows:

TABLE

| MATERIAL (wt%) | A | B | C | D | E | F | G | H | I | J | K | L | M | N | O | P |
|---|---|---|---|---|---|---|---|---|---|---|---|---|---|---|---|---|
| Example 9 | 35 | - | - | - | 24.5 | - | 10 | - | 5 | 2 | 4 | - | 19 | - | 0.5 | - |
| Example 10 | - | 20 | - | - | - | 20 | - | - | 5 | 2 | 4 | - | - | 0.5 | - | - |
| Example 11 | - | - | 40 | - | 15 | - | - | - | 5 | 2 | 4 | 14 | - | - | - | 0.5 |
| Example 12 | - | - | - | 40 | - | - | 12 | 15 | 5 | 2 | 4 | - | - | - | - | - |

The formulations were prepared at 15% solids in ethylene dichloride:methyl ethyl ketone solution (2:1) and coated onto 4 mil (0.1 mm) polyester with a number 12 Meier bar to provide a coating weight of about 300 mg/ft$^2$. The dried coatings were imaged with a 2KW Berkey-Ascor exposure unit for approximately 20 seconds with a diazo bulb. Useful images were obtained in all cases.

## Example 13

An aluminum layer 700 Å thick was vapor deposited on a 4 mil thick polyester substrate. Over the aluminum layer was coated an organic protective coat as taught in Example 6 of U.S. Patent No. 4,405,678. A crosslinkable, latently negative-acting photoresist base layer was prepared by mixing, in parts by weight:

| | |
|---|---|
| pentaerythritol tetraacrylate | 21 |
| partially esterfied 1:1 styrene: maleic anhydride resin | 21 |
| reaction product of a 5000-10,000 molecular weight polyol and 0.9 molar equivalents of isocyanate ethyl methacrylate per mole of available hydroxyl groups | 25 |
| carboxylic acid substituted polyacrylol functional urethane oligomer of Example 1 of U.S. Patent No. 4,304,923 | 8 |
| triarylsulfonium hexafluoroantimonate | 4 |
| Phthalo Blue pigment | 16.8 |
| carbon black | 4.2 |

The mixture was diluted using 2:1 ethylene dichloride: methyl ethyl ketone to 15% solids and coated over the protective coat at 2.2 g/m$^2$ solids. This was then dried at 105°C for 2 minutes.

A negative-acting photoresist composition was prepared by mixing, in parts by weight:

| | |
|---|---|
| pentaerythritol tetraacrylate | 21 |
| partially esterfied 1:1 styrene: maleic anhydride resin | 21 |
| reaction product of a 5000-10,00 molecular weight and 0.9 molar equivalents of isocyanate ethyl methacrylate per mole of available hydroxyl groups | 14 |
| carboxylic acid substituted polyacryloyl functional urethane oligomer of Example 1 of U.S. Patent No. 4,304,923 | 14 |
| Michler's ketone | 2 |
| diphenyliodonium hexafluorophosphate | 3 |
| s-triazine (compound 4, Table 1 of U.S. Patent No. 3,954,475) | 4 |
| Phthalo Blue pigment | 16.8 |
| carbon black | 4.2 |

The mixture was diluted with 2:1 ethylene dichloride:methyl ethyl ketone to approximately 15% solids and coated over the base layer at 2.2 $g/m^2$ solids. The coating was dried at 105°C for 2 minutes.

The thus prepared film was evaluated utilizing a halftone step wedge (Chauncey Scale) with 150 lines/in. halftone screens for positive and negative tint levels of 3, 5, 10, 20, 30, 40, 50, 60, 70, and 80 percent. A value of 5 points is assigned to each halftone area for a total of 100 points. Evaluation of each screen tint box provides a number from 0-5 with the following characteristics:

5 - all dots or holes present and of uniform good quality

4 - up to 10% of dots or holes non-uniform

3 - dots or holes present, but generally poor quality

2 - up to 40% of dots or holes missing, plugged or misformed

1 - more than 50% of dots or holes missing plugged or mixformed

0 - complete plugging in holes or no dots present.

The values for each of the twenty grading points are added together to obtain a resolution value.

The prepared film was exposed in a Berkey-Ascor 2 KW lithographic imaging system for 15 sec., washed and lightly scrubbed using, as the developer, Solution C of Example 3 of U.S. Patent No. 4,314,022. The resolution value for the film of this example is 85-100, showing excellent resolution.

Example 14

A film was prepared as in Example 1. To this film were added a matte top coat and an antistatic coating as follows:

A matte top coat was prepared by mixing, in parts by weight:

| | |
|---|---|
| polyvinyl alcohol (10% by weight in deionized water) | 75.0 |
| polymethylmethacrylate (6 microns avg. size as 13% solids in deionized $H_2O$) | 19.2 |
| ethylene oxide-propylene oxide block polymer surfactant (10% in deionized water) | 4.8 |
| n-propanol | 50.0 |
| deionized water | 851.0 |

The mixture was diluted to 2% solids with water and applied to the photoresist layer at 1.0 $g/m^2$ solids. This coating was dried at 100°C.

An anti-static coating is prepared by neutralizing a polystyrene sulfonate resin to pH 7 with sodium hydroxide. The solution is further diluted with 70:30 isopropanol:water to 5% solids and applied to the backside of the substrate at 0.3 $g/m^2$ solids. The coating

was dried at 100°C.

The film was tested for resolution as in Example 1. The film had excellent resolution with a resolution value of 85-100. The handleability characteristics of the film were improved over that of Example 1.

Example 15

A film was prepared as in Example 2, substituting the following non-pigmented composition for the base layer, with amounts in parts by weight.

| | |
|---|---|
| partially esterified 1:1 styrene:maleic anhydride resin | 11.6 |
| difunctional cycloaliphatic epoxide | 5.7 |
| pentaerythritol tetraacrylate | 18.4 |
| partially esterfied 1:1 styrene maleic anhydride resin | 40.2 |
| reaction product of a 5000-10,000 molecular weight polyol and 0.9 molar equivalents of isocyanate ethyl methacrylate per mole of available hydroxyl groups | 18.4 |
| triarylsulfonium hexafluoroantimonate | 5.7 |

The film was evaluated as in Example 1. The resolution value for this film was 85-100, showing excellent resolution.

Example 16

A film was prepared as in Example 2, substituting the following composition for the base layer, with amounts in parts by weight.

| | |
|---|---|
| partially esterified 1:1 styrene:maleic anhydride resin | 9.3 |
| difunctional cycloaliphatic epoxide | 4.7 |
| pentaerythritol tetraacrylate | 15 |
| partially esterfied 1:1 styrene: maleic anhydride resin | 32.7 |

| | |
|---|---|
| reaction product of a 5000-10,000 molecular weight polyol and 0.9 molar equivalents of isocyanate ethyl methacrylate per mole of available hydroxyl groups | 15 |
| triarylsulfonium hexafluoroantimonate | 4.7 |
| Phthalo Blue pigment | 18.6 |

The film was evaluated as in Example 1. The resolution value for this film was 85-100, showing excellent resolution.

Comparative Example 1

A film was prepared as in Example 1, omitting the base layer, and applying the photoresist layer at a thickness of 4.4 $g/m^2$. The film was evaluated as in Example 1 and had a resolution value of 60-80.

Comparative Example 2

A film was prepared as in Example 1, substituting a layer of photoresist coating for the base layer, to achieve a film having no base layer and two layers of photoresist coating. The film was evaluated as in Example 1 and had a resolution value of 60-80.

Various modifications and alterations of this invention will be apparent to those skilled in the art without departing from the scope and spirit of this invention and this invention should not be restricted to that set forth herein for illustrative purposes.

Claims:

1. A negative-acting photosensitive resist composition comprising:

a) at least one polyfuncitonal acrylate monomer,

b) an organic, polymeric, film-forming binder with more than one pendant acryloyl group pendant therefrom,

c) a polyfunctional, thermally activated, acid group crosslinking agent,

d) an active, photosensitive free-radical generator,

e) a non-active, photosensitive free-radical generator, and

f) an acid group-bearing polymeric binder.

2. The composition of claim 1 wherein said at least one polyfunctional acrylate monomer comprises 10-50 weight percent of the composition, said film-forming binder comprises between 10 and 60 weight percent of the composition, said acid group crosslinking agent comprises between 0.05 and 2.5 weight percent of the composition.

3. The composition of claim 2 wherein said active, photosensitive free-radical generator and said non-active, photosensitive free-radical generator individually comprises between 1 and 10 weight percent of the composition, and an effective amount of a spectral sensitizer for said non-active free-radical generator is also present.

4. The composition of claim 1 wherein said at least one polyfunctional acrylate monomer comprises 10 to 50 weight percent of said composition,

and film forming binder comprises 10 to 60 weight percent of said composition,

said acid group crosslinking agent comprises 0.05 to 2.5 weight percent of said composition,

said active, photosensitive free-radical generator comprises 1 to 10 weight percent of said composition,

said non-active, photosensitive free-radical generator comprises 1 to 10 weight percent of said composition, and

said acid group bearing organic polymeric binder comrpises 10 to 60 percent of said composition, said composition further comprising a spectral sensitizer present in an amount equal to 0.1 to 2 molar parts per mole of said non-active, photosensitive, free-radical generator.

5. The composition of claim 4 wherein said at least one polyfunctional acrylate monomer has 2 to 8 groups selected form the group consisting of acryloyl and methacryloyl,

said film-forming binder has a molecular weight between 1,000 and 100,000, and

said acid group bearing organic polymeric binder has a molecular weight between 1,000 and 100,000.

6. The composition of claim 5 wherein said acid group bearing organic polymeric binder has pendant carboxylic acid groups.

7. The composition of claim 4 wherein said acid group crosslinking agent is selected from the group consisting of aziridines, epoxy resins, and mixed aziridine-epoxy compounds.

8. The composition of claim 6 wherein said acid group crosslinking agent is selected from the group consisting of aziridines, epoxy resins, and mixed aziridine-epoxy compounds.

9. The composition of claim 4 wherein said active, photosensitive free-radical generator comprises an s-triazine.

10. A negative-acting photoresist imaging system comprising:

a) a substrate;
b) a metal layer adhered to said substrate;
c) a latently sensitized crosslinkable, negative-acting photoresist base layer adhered to said metallic layer, said base layer comprising:
   i) a polyfunctional acrylate monomer;
   ii) an organic, polymeric, polyfunctional film-forming binder with more than one acryloyl group pendant therefrom;
   iii) a polyfunctional, thermally activated, acid group crosslinking agent;
   iv) an acid group-bearing polymeric binder; and
   v) a non-active, photosensitive free-radical generator; and
d) a negative-acting photoresist layer adhered to said base layer, said photoresist layer comprising the composition of claims 1, 2, 3, 4, 5, 6, 7, 8 or 9.